# EUROPEAN PATENT APPLICATION

(11) **EP 3 179 522 A1**
(43) Date of publication of application: **14.06.2017**
(21) Application number: 15306957.0
(22) Date of filing: 08.12.2015
(51) Int. Cl.: H01L 31/18

(54) **METHOD FOR MANUFACTURING INTER-DIGITATED BACK CONTACT PHOTOVOLTAIC DEVICES**

(71) Applicant: TOTAL MARKETING SERVICES, 92800 Puteaux (FR); École Polytechnique, 91120 Palaiseau (FR); Centre National de la Recherche Scientifique, 75016 Paris (FR)
(72) Inventor: LEAL, Ronan, 91120 Palaiseau (FR); POULAIN, Gilles, 91120 Palaiseau (FR); DAMON-LACOSTE, Jérôme, 92160 Antony (FR)
(74) Representative: Jacobacci Coralis Harle

(57) **Abstract**

The invention concerns a method for manufacturing an IBC device comprising the steps of:
a) providing a crystalline silicon substrate (1) having a back surface (12);
b) forming first masked areas (22) and first opened areas (21) ;
c) first selective epitaxial PECVD step, so as to deposit a first crystalline silicon layer (31) on the first opened areas (21) and a non-crystalline silicon layer (32) on the first masked areas (22) ;
d) depositing a second dielectric layer (4) ;
e) selectively etching the first dielectric layer (2) for forming second opened areas (42) and second masked areas (41) coating the first crystalline silicon layer (31);
f) second selective epitaxial PECVD step, so as to deposit a second crystalline silicon layer (52) on the second opened areas (42) and a second non-crystalline silicon layer (51) on the second masked areas (41) ;
g) selectively etching the second dielectric layer (4).

## Description

### TECHNICAL FIELD OF THE INVENTION

The invention relates to a method for manufacturing solar cells.

More precisely the invention relates to an inter-digitated back contact (IBC) photovoltaic device and a method for manufacturing IBC photovoltaic devices.

Inter-digitated back contact (IBC) solar cell structures are based on thin junction devices having all contacts on the rear side of the device. The emitter and the back-surface field (BSF) contact are shaped in inter-digitated fingers so as to minimize recombination losses and maximize carrier collection. The rear contact structure of an IBC solar cell enables to reduce shadowing losses as compared to solar cells having front contact grids.

### BACKGROUND INFORMATION AND PRIOR ART

Currently, IBC solar cell manufacturing implies many technological steps, and some at high temperature (>600°C), especially for the back junction formation.

Conventional manufacturing processes are based on multiple steps including deposition, photolithography and etching, for forming precisely aligned inter-digitated emitter and back contact stacks. However, these processes require expensive tools for photolithography and use specific materials for example in masking steps.

Moreover, steps at high temperature may induce oxygen precipitates in the silicon substrate. Thus, high quality silicon ingots with stringent oxygen specifications and increased cost are generally required for IBC solar cells.

Recently, methods for manufacturing IBC solar cells using one step of low-temperature epitaxial growth by Plasma Enhanced Chemical Vapor Deposition (PECVD) have been proposed.

For example, the patent document US8829339 discloses a method for forming a field effect inter-digitated back contact photovoltaic device comprising deposition of a doped silicon layer on a patterned dielectric layer, so that selective epitaxial growth occurs in portions in contact with the crystalline silicon substrate, and non-crystalline growth occurs in portions in contact with the patterned dielectric. The doped crystalline layer serves as a first contact region (an emitter or a BSF contact) while the doped non-crystalline layer induces charges of opposite type in the substrate under the dielectric mask and serves as a second contact region (BSF or emitter), having a conductivity type opposite to that of the first region. Metal contacts are formed and aligned on the emitter and BSF stacks, respectively. An etching step is necessary for electrically separating the metal contacts. This IBC heterojunction structure presents inter-digitated back contacts, wherein the first contact (emitter or BSF) comprises a doped crystalline layer formed on the back surface and the second contact (BSF or emitter) comprises regions in the substrate at or near the interface with a dielectric mask deposited on the back surface.

### SUMMARY OF THE INVENTION

One object of the invention is to provide alternative processes and/or structures for IBC technologies at reduced manufacturing costs. More specifically, there is a need to propose alternative low temperature processes implying a smaller number of processing steps without reducing the quality of the IBC devices.

A further object of the invention is to provide an IBC photovoltaic junction device having high quality emitter and back surface field contacts, providing high electronic mobility and high carrier density.

The above objects are achieved according to the invention by providing a method for manufacturing an inter-digitated back contact photovoltaic device comprising the steps of:
a) providing a monocrystalline or multicrystalline silicon substrate having a front surface and a back surface ;
b) forming first masked areas made of a first dielectric layer on the back surface and forming first opened areas on the back surface, the first opened areas being inter-digitated with the first masked areas ;
c) exposing the first opened areas and the first masked areas of the back surface to a first selective epitaxial growth process which leads to an epitaxial growth in the first opened areas and an amorphous silicon deposition in the first masked areas, the first process comprising a plasma enhanced chemical vapor deposition in a gas mixture doped with a first type dopant, under determined PECVD conditions, so as to deposit selectively a first type doped crystalline silicon layer on the first opened areas of the back surface and a first type doped non-crystalline silicon layer on the first masked areas of the back surface;
d) depositing a second dielectric layer on the first type doped crystalline and non-crystalline silicon layers;
e) selectively etching the first dielectric layer and removing the first type doped non-crystalline silicon layer so as to form second opened areas on the back surface while forming second masked areas comprising a part of the second dielectric layer coating the first type doped crystalline silicon layer;
f) exposing the second opened areas and the second masked areas of the back surface to a second selective epitaxial growth process by plasma enhanced chemical vapor deposition in another gas mixture doped with a second type dopant, under determined PECVD conditions so as to deposit selectively a second type doped crystalline silicon layer on the second opened areas of the back surface and a second type doped non-crystalline silicon layer on the second masked areas;
g) selectively etching the second dielectric layer and removing the second type doped non-crystalline silicon layer so as to obtain the first type doped crystalline silicon layer inter-digitated with the second type doped crystalline silicon layer on the back surface of the substrate.

This method enables low temperature formation of inter-digitated back contact junction devices. Selective epitaxial PECVD growth processes, especially using silicon tetrafluoride (SiF₄) source gas, provides high quality crystalline silicon emitter and BSF contacts. The method enables reducing the number of processing steps for the manufacture of back junctions IBC solar cells. Further, the method provides automatic alignment of p-type and n-type inter-digitated fingers. The emitter and the BSF contacts are both made of crystalline material and are in lateral contact with each other, thus providing high quality emitter and the BSF contacts.

According to a particular aspect, the method for manufacturing an inter-digitated back contact photovoltaic device further comprises a step of texturing the front surface of the crystalline silicon substrate so as to form a textured front surface, prior to applying the steps b) through g) to the back surface.

In a particular embodiment, the above step of texturing the front surface comprises a step of wet etching applied to the front surface and to the back surface, the back surface being coated by the first dielectric layer, or a step of wet or dry etching applied only to the front side. These steps are for example intended to etch the damaged layers by the sawing.

According to another particular aspect, the method for manufacturing an inter-digitated back contact photovoltaic device, further comprises a step of chemical mechanical polishing the back surface of the crystalline silicon substrate, prior to applying the steps b) through g).

According to an advantageous embodiment of the invention, the step b) comprises the steps of:
b1) depositing a first dielectric layer on the back surface;
b2) spatially selective etching the first dielectric layer so as to form the first opened areas and the first masked areas on the back surface.

According to a particular embodiment, the step b2) comprises a step of wet or dry etching.

According to another particular aspect, the step e) comprises a wet etching step, so as to lift-off the first dielectric layer of the first masked areas together with the first type doped non-crystalline silicon layer.

According to an advantageous embodiment of the invention, the method further comprises a step of forming electric contacts on the first type doped crystalline silicon layer and other electric contacts on the second type doped crystalline silicon layer.

According to a particular and advantageous embodiment of the invention, the step c) and/or f) comprises a PECVD process in a gas mixture of silicon tetrafluoride, dihydrogen and argon or in a gas mixture of silane and dihydrogen.

Preferentially, the steps c) and f) are applied in a temperature range from 120 to 450°C, and the steps b) and d) are applied at a temperature lower than 500°C.

The invention also provides an inter-digitated back contact photovoltaic device comprising a monocrystalline or multicrystalline silicon substrate having a front surface and a back surface, a back surface emitter inter-digitated with a back surface field contact, the back surface emitter comprising a first type doped crystalline silicon layer formed directly on the back surface of the crystalline silicon substrate, and the back surface field contact comprising a second type doped crystalline silicon layer formed directly on the back surface of the crystalline silicon substrate, the back surface emitter and back surface field contact having different conductivity types, preferably opposed conductivity types.

The invention applies in particular to high efficiency IBC solar cells and to IBC optoelectronic devices.

The present invention also concerns the features disclosed in the following description and which are to be considered alone or according to any feasible technical combination.

### BRIEF DESCRIPTION OF THE DRAWINGS

This description is given for non limiting illustrative purposes only and will be better understood when referring to the annexed drawings wherein:
- Figure 1 represents a cross-sectional view of a silicon substrate having a first dielectric layer formed on the rear side;
- Figure 2 represents a cross-sectional view of a silicon substrate having a textured front side surface;
- Figure 3 represents a cross-sectional view of a silicon substrate having a first dielectric mask on the rear side;
- Figure 4 represents in cross-sectional view a first step of selective epitaxial growth on the first dielectric mask at the rear side of a silicon substrate;
- Figure 5 represents in cross-sectional view deposition of a second dielectric layer;
- Figure 6 represents in cross-sectional view a step of etching the first dielectric mask and forming a second dielectric mask;
- Figure 7 represents in cross-sectional view a second step of selective epitaxial growth;
- Figure 8 represents in cross-sectional view a step of etching the second dielectric mask.

### DETAILED DESCRIPTION OF EXAMPLE(S)

The method enables production of IBC devices using only a single patterning step while forming auto-aligned inter-digitated crystalline emitter and crystalline back surface field contacts. The method employs low temperature epitaxial growth processes and provides high quality crystalline emitter and BSF contacts, grown by low temperature epitaxy.

Within the present disclosure, it will be understood that a stack in a photovoltaic device comprises at least an element, such as a layer, an area of a surface, or a portion of the substrate, placed "on" or "over" or "under" another element. Two elements of a same stack are not necessary in contact with each other since they may be separated by other element(s) of the stack. An element "directly on" or "directly over" or "directly under" another element means that two such elements are in contact with each other.

### Process

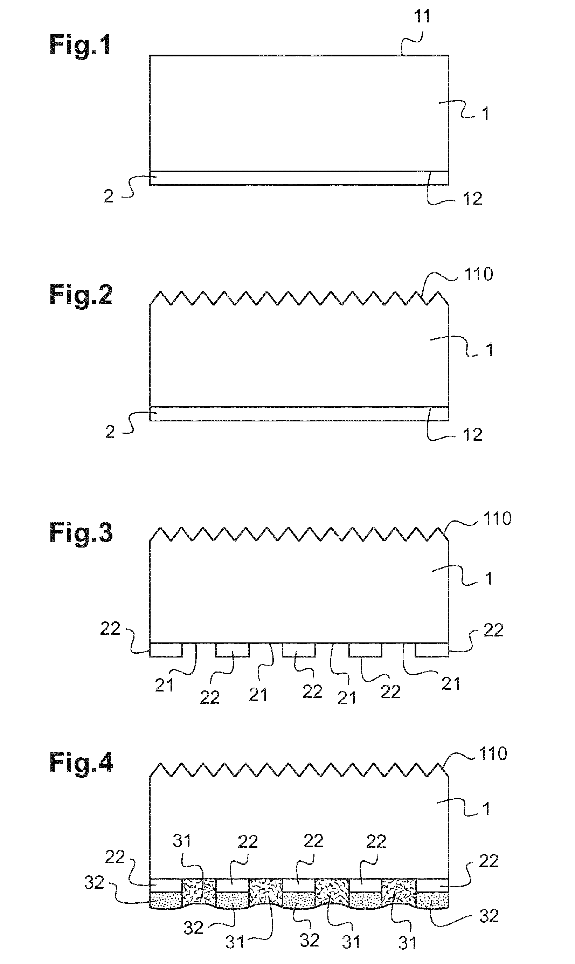

An illustrative embodiment of a method for manufacturing an IBC device is disclosed in reference with figures 1-8.

Fig. 1 shows a cross-sectional view of a monocrystalline or multicrystalline silicon substrate 1. The monocrystalline or multicrystalline silicon substrate 1 has a front surface 11 and a back surface 12. In a preferred embodiment, the substrate is monocrystalline and the back surface 12 is polished for example by Chemical Mechanical Polishing (CMP), in order to obtain a planar back surface 12. The back surface 12 presents a determined, preferably <100>, crystallographic orientation.

A dielectric layer 2 is deposited on the back surface 12. Preferably, the dielectric layer 2 comprises an amorphous material preferentially silicon oxide layer deposited by PECVD at low temperature (in general less than 500°C). The dielectric layer 2 has a thickness in the range of 20 nm to 500 nm.

Figure 2 shows a cross-sectional view of the silicon substrate 1 having a textured front side surface 110. Within the frame of the present disclosure, front side texturing is an optional step. Front side texturing may result from a wet etching step. For example, the whole substrate 1 is dipped into a texturing solution such as KOH or HCl. The front surface 11 of the silicon substrate 1 is etched, thus forming a textured front side surface 110. The dielectric layer 2 on the rear side of the substrate 1 favorably prevents etching of the rear surface 12, even though the dielectric layer 2 may be slightly etched by the texturing solution, which is not a real drawback. In an alternative texturing example, texturing is applied only to the front surface 11 of the substrate. Single side texturing may be realized by dry or wet etching techniques. Single side wet etching requires a dedicated wet-bench equipment which advantageously preserves the rear side dielectric layer 2 unaffected.

Figure 3 represents a cross sectional view of the silicon substrate after a step of dielectric opening on the rear side for forming a first dielectric mask. A spatially selective dry or wet etching step is applied to the dielectric layer 2 so as to form first opened areas 21 and the first masked areas 22. Preferably, this dielectric etching step is realized by laser ablation or by wet etching, for example using an etching paste. This etching paste is applied selectively to some areas of the dielectric layer 2 so as to uncover regions of the back surface 12, thus forming opened areas 21, while preserving at least a part of the dielectric layer in the other areas, so as to form masked areas 22 of dielectric layer. The opened areas 21 present the crystalline silicon surface with preferentially <100> orientation. The generation of masked areas 22 is thus realized without implying photolithography.

As viewed from the rear surface 12, the first opened areas 21 and the first masked areas 22 have fingers shapes and are inter-digitated. In the plane of the back surface 12, the widths of the first opened areas 21 and the first masked areas 22 may be identical or not. The respective widths of the opened and masked areas may range from 50 µm to 1500 µm. The thickness of the first masked areas 22 is generally in the range from about 20 nm to 500 nm.

Figure 4 represents a cross sectional view of the silicon substrate after a first step of selective epitaxial growth. RF-PECVD (Radio Frequency Plasma Enhanced Chemical vapor Deposition) is preferably used in a chemical gas mixture of silane (SiH₄) and H₂ or in a gas mixture of silicon tetrafluoride (SiF₄), dihydrogen (H₂) and argon (Ar). Moreover, a first dopant species is used for doping the deposited layer with a first type dopant. For example, the first dopant gas is selected among diborane or trimethylborane for p-type doping, or phosphine for n-type doping. In the following description, the first dopant is n-type. In the case of SiF₄/H₂/Ar chemistry, the gas flow rate ratio is below 1 for H₂/SiF₄, is in between 5 and 20 for Ar/SiF₄, is in between 1/2000 and 20/2000 for PH₃/SiF₄. In the case of SiH₄/H₂ chemistry, the gas flow rate ratio is in between 20 and 100 for H₂/SiH₄, is in between 1/100 and 20/100 for PH₃/SiH₄. During deposition, the gas dopant flow rate can be set to a constant value or be varied in order to tune the doping concentration along the emitter depth.

The RF-PECVD is performed in a vacuum reaction chamber under following conditions: RF power between 0,08W/cm² and 0,50W/cm², pressure between 500mT and 5T, temperature between 120°C and 450°C, inter electrode distance between 10mm and 35mm. The RF-PECVD conditions are precisely controlled so as to provide epitaxial growth of an n-doped crystalline silicon layer 31 on the first opened areas 21 which expose the bare crystalline silicon surface, while simultaneously providing growth of an n-doped non-crystalline silicon layer 32 on the dielectric layer of the first masked areas 22. As an example, the thickness of the n-doped crystalline silicon layer 31 is in the range 25 nm - 500 nm. As a result of this first selective epitaxial growth, a first stack is formed which consists of n-doped crystalline silicon layer 31 formed directly on the opened areas 21 of the back surface 12, and a second stack is formed consisting of a dielectric layer forming the masked areas 22, coated by a n-doped non-crystalline silicon layer 32. The first stack and the second stack are inter-digitated.

The n-doped crystalline silicon layer 31 formed by epitaxy has excellent quality as concerns carrier mobility. The n-doped non-crystalline silicon layer 32 is for example amorphous.

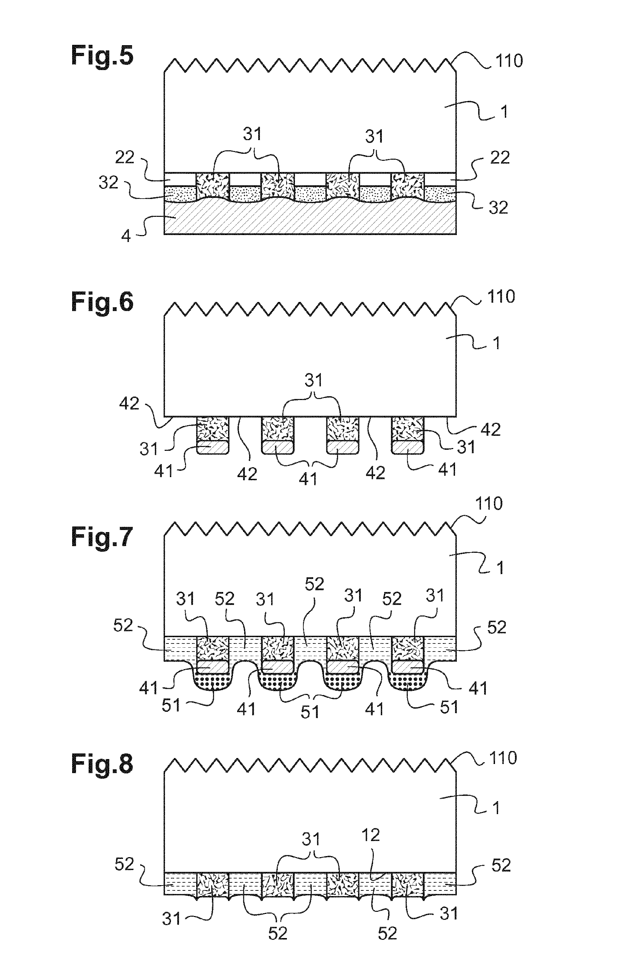

Fig. 5 shows a cross-sectional view of the substrate after deposition of a second dielectric layer 4 on the back side of the device. The second dielectric layer 4 is deposited uniformly on the n-doped crystalline silicon layer 31 and on the n-doped non-crystalline silicon layer 32. The second dielectric layer 4 is for example a layer of silicon oxide (SiOₓ) or silicon nitride (SiN). This second dielectric layer 4 may be deposited by RF-PECVD, at low temperature, in the same vacuum chamber as the first selective epitaxial growth step or in a different vacuum chamber of a same cluster tool. The second dielectric layer 4 has a thickness in the range of 20 nm to 500 nm. Preferably, the second dielectric layer 4 thickness is greater than the thickness of the first dielectric layer 22 in the first masked areas. In an example, the second dielectric thickness is equal to at least twice the thickness of the first dielectric layer 22 in the first masked areas.

Figure 6 shows a cross sectional view of the device after another selective etching step. This selective etching step is for example performed by wet etching such as HF solution applied to the rear side of the device. The etching conditions are determined so as to etch preferentially the first dielectric layer 22. The etching is material-selective in that dielectric layers are etched at higher speed than epitaxial silicon layers. However, etching is controlled so as to etch only partially the second dielectric layer, in order to preserve a second dielectric masking layer on top of the crystalline silicon layer 31.

In a preferred embodiment, this etching step enables to etch the first dielectric layer forming the first masked areas 22 so as to simultaneously lift-off the whole stack of materials deposited on this first dielectric layer. As a result, the non-crystalline silicon layer 32 and the portions of the second dielectric layer deposited directly on the non-crystalline silicon layer 32 are removed simultaneously. The other portions of the second dielectric layer deposited directly on the crystalline silicon layer 31 are not fully etched, and form second masked areas 41 directly on the n-doped crystalline silicon layer 31. For example, after this etching step, the thickness of the second dielectric layer forming the second masked areas 41 is in the range 20 nm - 450 nm.

Removal of the stack comprising the first dielectric layer forming the first masked areas 22 enables forming second opened areas 42 in between the stacks comprising the n-doped crystalline silicon layer 31 and the second masked areas 41. The second opened areas 42 expose directly the rear surface of the crystalline silicon substrate.

Figure 7 shows a cross-sectional view of the substrate after a second step of selective epitaxial growth. This step is also performed preferably by RF-PECVD in a chemical gas mixture of silane (SiH₄) and H₂ or silicon tetrafluoride (SiF₄), dihydrogen (H₂) and argon (Ar). A second dopant species is used for doping the deposited layer with a second type dopant, of opposed conductivity type to the first dopant. In an example, the first dopant is n-type and the second dopant is p-type. In this step, the RF-PECVD is performed in the same vacuum reaction chamber as the first epitaxial growth or in another chamber of a cluster tool, under following conditions. In the case of SiF₄/H₂/Ar chemistry, the gas flow rate ratio is below 1 for H₂/SiF₄, is in between 5 and 20 for Ar/SiF₄, is in between 1/2000 and 20/2000 for B₂H₆/SiF₄. In the case of SiH₄/H₂ chemistry, the gas flow rate ratio is in between 20 and 100 for H₂/SiH₄, is in between 1/100 and 20/100 for B₂H₆/SiH₄. Again, during deposition, the gas dopant flow rate can be set to a constant value or be varied in order to tune the doping concentration along the emitter depth. In both cases RF power is between 0,08W/cm² and 0,50W/cm², pressure between 500mT and 5T, temperature between 120°C and 450°C, inter electrode distance between 10mm and 35mm. The RF-PECVD conditions are precisely controlled so as to provide epitaxial growth of a p-doped crystalline silicon layer 52 on the second opened areas 42 which expose the bare crystalline silicon surface, while simultaneously providing growth of a p-doped non-crystalline silicon layer 51 on the second dielectric layer of the second masked areas 41. Preferably, the thickness of the p-doped crystalline silicon layer 52 is about the same as the thickness of the n-doped crystalline silicon layer 31, and lies in the range 25 nm - 500 nm. The p-doped crystalline silicon layer 52 grows epitaxially from the surface of the crystalline silicon substrate and/or from the transverse surfaces of the n-doped crystalline silicon layer 31 which form the walls of the second opened areas 42. As a result, the p-doped crystalline silicon layer 52 fills completely the spaces in between adjacent stacks of n-doped crystalline silicon layer 31.

As a result of this second selective epitaxial growth, the structure schematically represented on figure 7 shows alternated stacks. A first stack consists of n-doped crystalline silicon layer 31 grown directly on the back surface of the crystalline substrate, a second dielectric layer 41, and a p-doped non-crystalline silicon layer 51. The second stack consists of the p-doped crystalline silicon layer 52. The first stack and the second stack are inter-digitated.

The p-doped crystalline silicon layer 52 formed by epitaxy has excellent quality as concerns carrier mobility. The p-doped non-crystalline silicon layer 51 is for example amorphous.

Figure 8 shows a cross sectional view of the device after another selective etching step. This etching step is for example performed by wet etching, to remove the second dielectric layer 41 so as to lift-off simultaneously the p-doped non-crystalline silicon layer 51.

Figure 8 thus shows the IBC junction device obtained, which comprises alternated inter-digitated n-doped crystalline silicon layer 31 and p-doped crystalline silicon layer 52 on the rear surface of a crystalline silicon substrate 1. The n-doped fingers and p-doped fingers are auto-aligned by construction.

Further conventional surface treatments may be applied to the rear side, for example metal deposition, and/or to the front side of the IBC device.

The disclosed IBC manufacturing process is compatible with numerous variations in designs, shapes and dimensions of the emitter and back surface contacts.

The process disclosed referring to figures 1-8 employs a very limited number of steps and a limited number of processing tools. A PECVD reactor and an etching setup such as wet bench or a laser or an etching paste are sufficient for producing an IBC device according to the invention.

The operational costs are limited due to the limited number of process steps and to the low temperature of the PECVD process. Moreover, the low temperature reduces oxygen precipitates in silicon wafers. This allows to use wafers with higher oxygen concentration than previously required. This allows a more efficient use of silicon ingots.

### Device

As a result of the process disclosed above, the structure of the IBC device illustrated on Figure 8 comprises alternated inter-digitated n-doped crystalline silicon layer 31 and p-doped crystalline silicon layer 52 on the rear side of a crystalline silicon substrate 1. Preferably, the n-doped crystalline silicon layer 31 and p-doped crystalline silicon layer 52 have about the same thickness. In the illustrated drawing, the n-doped fingers and p-doped fingers have the same widths, however other designs are considered. The front side may comprise a textured surface 110, and optionally surface passivation layers.

Metal contacts may be deposited respectively on the n-doped and p-doped crystalline silicon layers 31, 52 so as to complete the IBC junction device.

Since both n-doped and p-doped crystalline silicon layers 31, 52 are grown by epitaxy and directly on the rear surface 12 of the crystalline silicon substrate 1, these layers 31, 52 have excellent quality as concerns carrier mobility, generally higher than 40cm²/V/s for highly doped p-type epitaxial silicon.

The emitter and the BSF contacts are both made of crystalline material and are in lateral contact with each other.

Such an IBC structure provides a fully crystalline electronic junction, thus providing high carrier mobility. Improved solar cell efficiency and lower production cost are expected.

The dimensions and shapes of the emitter and back surface contacts of the disclosed IBC structure can be varied in numerous ways and over broad ranges.

Of course, other dopant combinations are considered within the scope of the present disclosure.

## Claims

1. Method for manufacturing an inter-digitated back contact photovoltaic device comprising the steps of:
a) providing a monocrystalline or multicrystalline silicon substrate (1) having a front surface (11, 110) and a back surface (12) ;
b) forming first masked areas (22) made of a first dielectric layer (2) on the back surface (12) and forming first opened areas (21) on the back surface (12), the first opened areas (21) being inter-digitated with the first masked areas (22) ;
c) exposing the first opened areas (21) and the first masked areas (22) of the back surface to a first process which leads to an epitaxial growth in the first opened areas (21) and an amorphous silicon deposition in the first masked areas (22), the first process comprising a plasma enhanced chemical vapor deposition in a gas mixture doped with a first type dopant so as to selectively deposit a first type doped crystalline silicon layer (31) on the first opened areas (21) of the back surface and a first type doped non-crystalline silicon layer (32) on the first masked areas (22) of the back surface ;
d) depositing a second dielectric layer (4) on the first type doped crystalline and non-crystalline silicon layers (31, 32) ;
e) selectively etching the first dielectric layer (2) together with the first type doped non-crystalline silicon layer (32) so as to form second opened areas (42) on the back surface (12) while forming second masked areas (41) comprising a part of the second dielectric layer (4) coating the first type doped crystalline silicon layer (31);
f) exposing the second opened areas (42) and the second masked areas (41) of the back surface to a second selective epitaxial growth process by plasma enhanced chemical vapor deposition process in another gas mixture doped with a second type dopant, so as to deposit selectively a second type doped crystalline silicon layer (52) on the second opened areas (42) of the back surface and a second type doped non-crystalline silicon layer (51) on the second masked areas (41) ;
g) selectively etching the second dielectric layer (4) together with the second type doped non-crystalline silicon layer (51) so as to obtain the first type doped crystalline silicon layer (31) inter-digitated with the second type doped crystalline silicon layer (52) on the back surface (12) of the substrate (1).

2. Method for manufacturing an inter-digitated back contact photovoltaic device according to claim 1 further comprising a step of texturing the front surface (11) of the crystalline silicon substrate (1) so as to form a textured front surface (110), prior to applying the steps b) through g) to the back surface (12).

3. Method for manufacturing an inter-digitated back contact photovoltaic device according to claim 2 wherein the step of texturing the front surface comprises a step of wet etching applied to the front surface (11) and to the back surface (12), the back surface (12) being coated by the first dielectric layer (2), or a step of wet or dry etching applied only to the front side (11).

4. Method for manufacturing an inter-digitated back contact photovoltaic device according to any one of claims 1 to 3, further comprising a step of chemical mechanical polishing the back surface (12) of the crystalline silicon substrate (1), prior to applying the steps b) through g).

5. Method for manufacturing an inter-digitated back contact photovoltaic device according to any one of claims 1 to 4, wherein the step b) comprises the steps of:
b1) depositing a first dielectric layer (2) on the back surface (12);
b2) spatially selective etching the first dielectric layer (2) so as to form the first opened areas (21) and the first masked areas (22) on the back surface (12).

6. Method for manufacturing an inter-digitated back contact photovoltaic device according to claim 5, wherein the step b2) comprises a step of wet or dry etching.

7. Method for manufacturing an inter-digitated back contact photovoltaic device according to any one of claims 1 to 6, wherein the step e) comprises a wet etching step, so as to lift-off the first dielectric layer (2) of the first masked areas (22) together with the first type doped non-crystalline silicon layer (32).

8. Method for manufacturing an inter-digitated back contact photovoltaic device according to any one of claims 1 to 7, further comprising a step of forming electric contacts on the first type doped crystalline silicon layer (31) and other electric contacts on the second type doped crystalline silicon layer (52).

9. Method for manufacturing an inter-digitated back contact photovoltaic device according to any one of claims 1 to 8, wherein the step c) and/or f) comprises a PECVD process in a gas mixture of silicon tetrafluoride, dihydrogen and argon or in a gas mixture of silane and dihydrogen.

10. Method for manufacturing an inter-digitated back contact photovoltaic device according to any one of claims 1 to 9, wherein the steps c) and f) are applied in a temperature range from 120 to 450°C, and wherein the steps b) and d) are applied at a temperature lower than 500°C.

11. Inter-digitated back contact photovoltaic device comprising a monocrystalline or multicrystalline silicon substrate (1) having a front surface (11, 110) and a back surface (12), a back surface emitter inter-digitated with a back surface field contact, the back surface emitter comprising a first type doped crystalline silicon layer (31) formed on the back surface (12) of the crystalline silicon substrate (1), and the back surface field contact comprising a second type doped crystalline silicon layer (52) formed on the back surface (12) of the crystalline silicon substrate (1), the first type doped crystalline silicon layer (31) and second type doped crystalline silicon layer (52) having different conductivity types.
